# EUROPEAN PATENT SPECIFICATION

(11) **EP 3 863 391 B1**
(45) Date of publication and mention of the grant of the patent: **04.09.2024**
(21) Application number: 18936036.5
(22) Date of filing: 04.10.2018
(51) Int. Cl.: H05K 13/08, H04N 23/56, H04N 23/74

(54) **CAMERA FOR CAPTURING COMPONENT IMAGES, AND COMPONENT MOUNTING MACHINE**
KAMERA ZUR AUFNAHME VON KOMPONENTENBILDERN UND BESTÜCKUNGSMASCHINE
CAMÉRA DESTINÉE À CAPTURER DES IMAGES DE COMPOSANT, ET MACHINE DE MONTAGE DE COMPOSANTS

(43) Date of publication of application: 11.08.2021
(73) Proprietor: Fuji Corporation, Chiryu-shi, Aichi 472-8686 (JP)
(72) Inventor: TANAKAMARU, Shigenori, Chiryu-shi, Aichi 472-8686 (JP); OKI, Hideaki, Chiryu-shi, Aichi 472-8686 (JP)
(74) Representative: Grünecker Patent- und Rechtsanwälte PartG mbB
(86) International application number: PCT/JP2018/037199
(87) International publication number: WO 2020/070858

(56) References cited:
- EP-A1- 1 057 389
- EP-B1- 1 057 389
- WO-A1-2013/018247
- WO-A1-2018/127971
- JP-A- 2000 124 683
- JP-A- 2002 352 232
- JP-A- 2003 174 292
- JP-A- 2005 109 288
- JP-A- 2006 210 531
- US-A1- 2010 305 756
- US-A1- 2019 364 182

## Description

### Technical Field

The present specification discloses a camera for capturing component images, and a component mounting machine.

### Background Art

Conventionally, as a camera for capturing component images, for example, as shown in JP-T-2003-536249, a camera that includes multiple lighting units for irradiating a printed board with LED light and an image capturing unit for capturing the printed board is known. In the camera for capturing the component images, the image capturing unit requests a flash pulse to the lighting unit via a request signal (turn-on command signal). The flash pulse is individually formed for each lighting unit in a pulse width modulator. An intensity of the flash pulse and a pulse period (LED turn-on time) are filed for each lighting unit in a parameter memory. Thus, it is said that the parameters can be adapted and changed in the lighting unit by a simple method in software without requiring manual adjustment of a pulse generating circuit.

### Patent Literature

Patent Literature 1: JP-T-2003-536249
Patent Literature 2: WO 2018/127971 A1 relates to an illumination device for illuminating an imaging target for a component mounter.

Four LED-mounted boards are arranged in a foursided shape centered around the light axis of the camera. Each LED-mounted board is divided into multiple illumination areas. The electric power supplied to each illumination area is individually adjusted. The LEDs of each illumination area are controlled to perform pulse lightning in synchronization with the shutter timing of the camera, and the on-time of the LEDs of each illumination area is changed individually for each illumination area in accordance with an imaging target type. Patent Literature 3: EP 1 057 389 A1 relates to an electronic component mounting apparatus that comprises an illumination device for emitting light onto the component, a CCD camera for recognizing the object and position it correctly for mounting. The illumination device may comprise a plurality of light sources, each of which comprising a plurality of light-emitting elements of different colours.

Patent Literature 4: US 2010/305756 A1 relates to an electronic component mounting machine comprising an image taking system including an image taking device and a lighting device capable of changing a light emission time to various time length values.

### Summary of the Invention

### Technical Problem

However, the request signal to the lighting unit only indicates a rising timing of the flash pulse, and it is unclear how much light amount the image capturing unit which outputs the request signal requests. Therefore, it was not possible to change the turn-on time of the lighting unit using the light amount required by the image capturing unit that outputs the request signal.

The present disclosure has been made in view of such a problem, and it is a main object of the present invention to easily set the turn-on time for each lighting unit by using the light amount required by a higher-order unit which outputs a turn-on command signal.

### Solution to Problem

The invention is defined by the features of the independent claims. Embodiments and examples not falling under the scope of the independent claims are for illustrational purposes only.

In the camera for capturing the component images, the lighting unit control section is provided for each lighting unit. In a case where the turn-on command signal including the turn-on command pulse is input from the higher-order unit, the lighting unit control section turns on the light emitting element for the turn-on time calculated by multiplying the pulse width time of the turn-on command pulse by the constant set for each lighting unit from the rising edge of the turn-on command pulse included in the turn-on command signal. Here, the pulse width time of the turn-on command pulse is an index representing how much light amount the higher-order unit requires. The lighting unit control section calculates the turn-on time by multiplying the pulse width time by the constant set for each lighting unit. Therefore, with the camera for capturing the component images of the present disclosure, it is possible to easily set the turn-on time for each lighting unit using the light amount required by the higher-order unit which outputs the turn-on command signal.

### Brief Description of Drawings

Fig. 1 is a perspective view of component mounting machine 10.
Fig. 2 is a schematic explanatory view of a configuration of component camera 40.
Fig. 3 is a block diagram showing a configuration related to control of component mounting machine 10.
Fig. 4 is a flowchart of a component mounting process.
Fig. 5 is a flowchart of a component image capturing process.
Fig. 6 is an explanatory view of an image in a case where BGA package 90 is captured by irradiating with red light.
Fig. 7 is an explanatory view of an image in a case where BGA package 90 is captured by irradiating with blue light.
Fig. 8 is an explanatory view of a turn-on command signal and related signals.
Fig. 9 is a flowchart of a turn-on process.

### Description of Embodiments

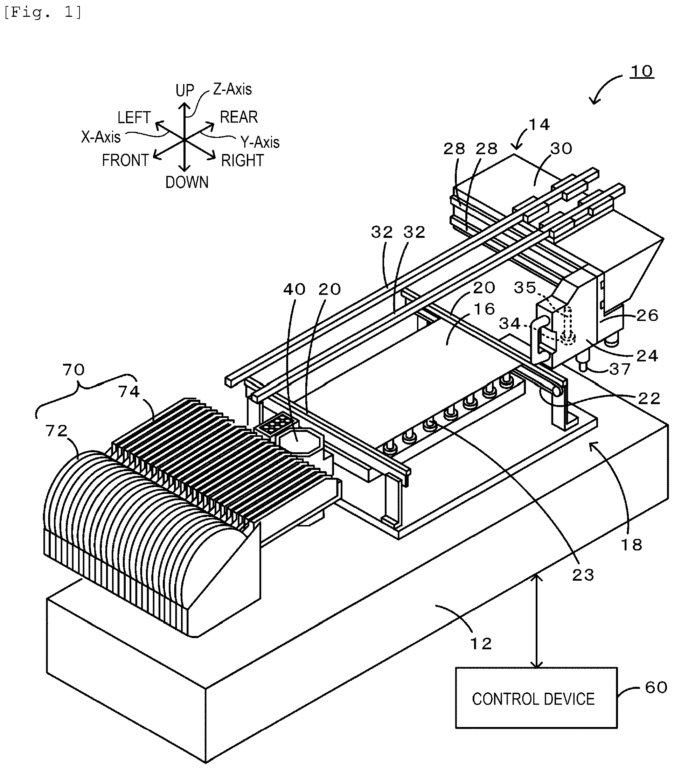

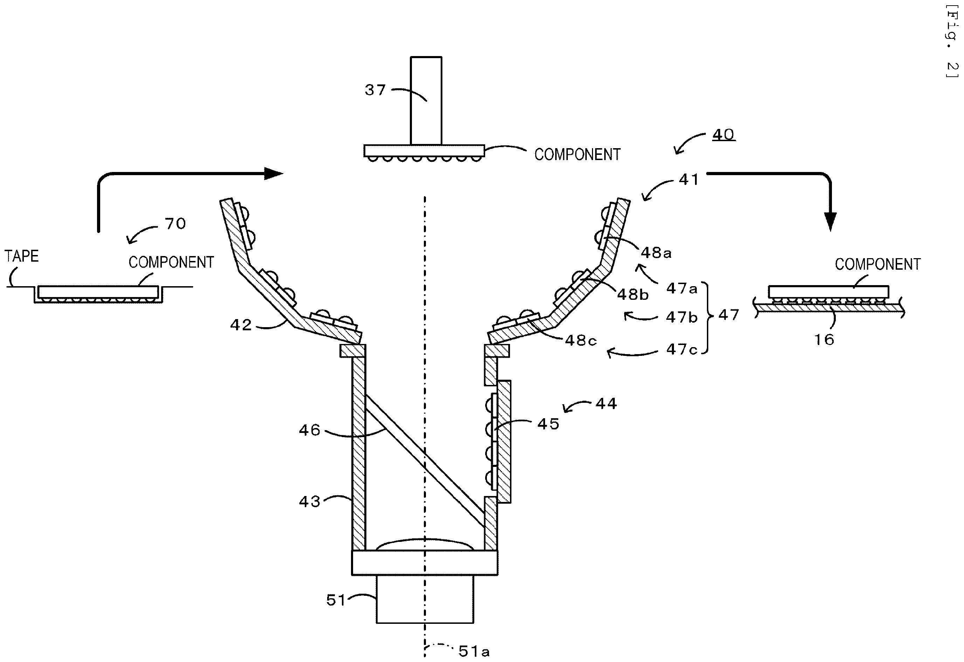

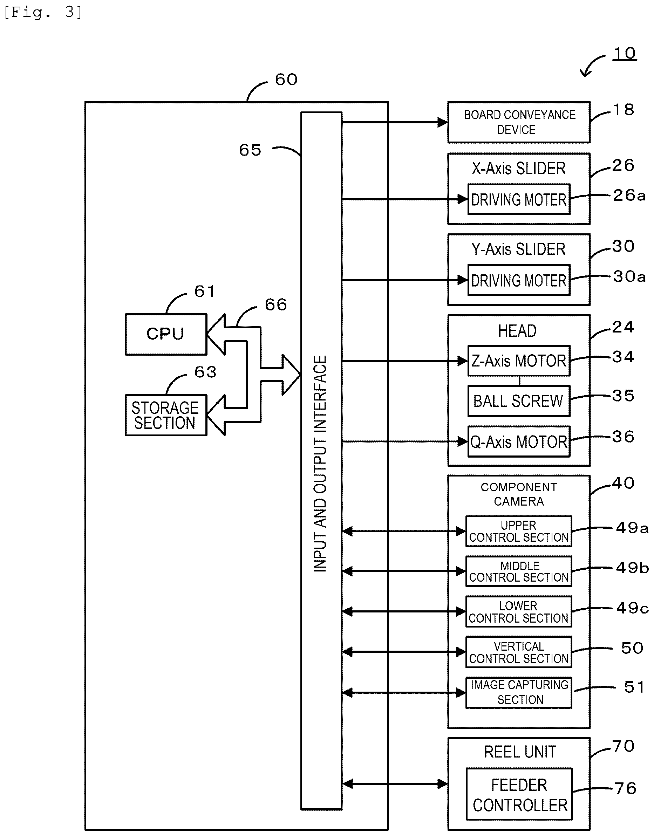

Hereinafter, referring to drawings, a preferred embodiment of an imaging processing method and an image processing device according to the present disclosure will be described. Fig. 1 is a perspective view of component mounting machine 10, Fig. 2 is a schematic explanatory view of a configuration of component camera 40, and Fig. 3 is a block diagram showing a configuration related to control of component mounting machine 10. In the present embodiment, a left-right direction (X-axis), a front-rear direction (Y-axis), and an up-down direction (Z-axis) are as shown in Fig. 1.

Component mounting machine 10 includes base 12, mounting machine body 14 installed on base 12, and reel unit 70 serving as a component supply device mounted on mounting machine body 14.

Mounting machine body 14 is installed to be exchangeable with respect to base 12. Mounting machine body 14 includes board conveyance device 18, head 24, nozzle 37, component camera 40, and control device 60.

Board conveyance device 18 is a device that conveys or holds board 16. Board conveyance device 18 includes support plates 20 and 20, and conveyor belts 22 and 22 (shown only one in Fig.1). The support plates 20 and 20 are members extending in the left-right direction, and are provided so as to be spaced apart from each other in the front-rear direction in Fig. 1. Conveyor belts 22, 22 are spanned over drive wheels and driven wheels provided on the left and right of support plates 20, 20 so that conveyor belts 22, 22 form endless loops. Board 16 is conveyed from left to right on upper surfaces of conveyor belts 22 and 22. Board 16 can be supported from a bottom surface side by support pin 23 erected at multiple locations. As a result, board conveyance device 18 also functions as a board supporting device.

Head 24 is attached to a front surface of X-axis slider 26. X-axis slider 26 is attached to a front surface of Y-axis slider 30. Y-axis slider 30 is slidably attached to a pair of left and right guide rails 32 and 32 extending in the front-rear direction. A pair of upper and lower guide rails 28 and 28 extending in the left-right direction are provided on the front surface of Y-axis slider 30. X-axis slider 26 is slidably attached to guide rails 28 and 28. Head 24 moves in the left-right direction as X-axis slider 26 moves in the left-right direction, and moves in the front-rear direction as Y-axis slider 30 moves in the front-rear direction. Each of sliders 26 and 30 is driven by driving motors 26a and 30a (refer to Fig. 3), respectively. In addition, head 24 embeds Z-axis motor 34, and the height of nozzle 37 attached to ball screw 35, which extends along the Z-axis, is adjusted by Z-axis motor 34. Furthermore, head 24 embeds Q-axis motor 36 (refer to Fig. 3) that axially rotates nozzle 37.

Nozzle 37 is a member that picks up and holds a component in a nozzle tip, and that releases the component picked up by the nozzle tip. Nozzle 37 can supply a pressure from a pressure supply source (not shown), for example, picks up the component in a case where a negative pressure is supplied, and releases the component in a case where the supply of the negative pressure is stopped or the positive pressure is supplied. Nozzle 37 protrudes downward from a bottom surface of a main body of head 24. In addition, the height of a component picked up by nozzle 37 is adjusted by moving nozzle 37 up and down along the Z-axis direction by Z-axis motor 34. Since nozzle 37 is rotated by Q-axis motor 36, an orientation of the component picked up by nozzle 37 is adjusted.

Component camera 40 is disposed in front of support plate 20 on a front side of board conveyance device 18. Component camera 40 has a capturing region above component camera 40, and generates a captured image by capturing the component held by nozzle 37 from below. Component camera 40, as shown in Fig. 2, includes lighting section 41, and image capturing section 51.

Lighting section 41 irradiates a component of a capturing target with light. Lighting section 41 includes housing 42, connecting portion 43, vertical lighting unit 44, half mirror 46, and multi-stage lighting section 47. Housing 42, the upper and lower surfaces (bottom surface) is a bowl-shaped member which is open in an octagonal shape. Housing 42 has a shape in which an opening of the upper surface is larger than an opening of the lower surface, and an internal space tends to increase from the lower surface toward the upper surface. Connecting portion 43 is a tubular member that connects housing 42 and image capturing section 51 to each other. Vertical lighting unit 44 has multiple LEDs 45 which are light emitting elements. Turning on LED 45 is controlled by vertical control section 50 provided with vertical lighting unit 44 (refer to Fig. 3). Half mirror 46 reflects horizontally light from LED 45 of vertical lighting unit 44 upward. In addition, half mirror 46 transmits toward the image capturing section 51 for light from above. Multi-stage lighting section 47 includes upper lighting unit 47a, middle lighting unit 47b, and lower lighting unit 47c. Upper lighting unit 47a has multiple LEDs 48a, middle lighting unit 47b has multiple LEDs 48b, and lower lighting unit 47c has multiple LEDs 48c. All of LEDs 48a to 48c irradiate the component with the light in a direction inclined from optical axis 51a. The inclination angle of LEDs 48a to 48c from optical axis 51a in the irradiation direction is the largest for LED 48a and the smallest for LED 48c. LED 48a irradiates the component with light in a substantially horizontal direction. In the present embodiment, LED 48a of upper lighting unit 47a is a blue LED, and LED 48b of middle lighting unit 47b, LED 48c of lower lighting unit 47c, and LED 45 of vertical lighting unit 44 are red LEDs. Turning on LED 48a is controlled by upper control section 49a (refer to Fig. 3) provided in upper lighting unit 47a, turning on LED 48b is controlled by middle control section 49b (refer to Fig. 3) provided in the middle lighting unit 47b, and turning on LED 48c is controlled by lower control section 49c (refer to Fig. 3) provided in lower lighting unit 47c. For example, a PLD (Programmable Logic Device) or the like can be used for vertical control section 50 and upper, middle, and lower control sections 49a to 49c.

Capturing section 51 generates a captured image, based on received light. Capturing section 51 includes an optical system such as a lens (not shown) and a capturing element (for example, CCD). In a case where light after being emitted from vertical lighting unit 44 and multi-stage lighting section 47 and reflected on the capturing target component reaches image capturing section 51 through half mirror 46, image capturing section 51 receives the light, and generates the captured image.

Reel unit 70 includes multiple reels 72, and is detachably attached to a front side of mounting machine body 14. A tape is wound around each reel 72. A surface of the tape has multiple accommodating recesses along a longitudinal direction of the tape. Each accommodating recess accommodates a component. The components are protected by a film covering the surface of the tape. The tape is unwound rearwardly from the reel and the film is peeled off at feeder section 74 to expose the component. The component in the exposed state is picked up by nozzle 37. The operation of reel unit 70 is controlled by feeder controller 76 (refer to Fig. 3).

As shown in Fig. 3, control device 60 includes CPU 61, storage section 63 (ROM, RAM, HDD, and the like), input and output interface 65, and the like, and these are connected to each other via bus 66. Control device 60 outputs a drive signal to board conveyance device 18, driving motor 26a of X-axis slider 26, driving motor 30a of Y-axis slider 30, Z-axis motor 34 and Q-axis motor 36 of head 24, image capturing section 51 of component camera 40, and a pressure supply source (not shown) for nozzle 37. In addition, control device 60 inputs the captured image from image capturing section 51 of component camera 40. Control device 60 is connected to feeder controller 76 of reel unit 70 and each of control sections 49a to 49c, and 50 of component camera 40 so as to be capable of bidirectional communication. Although not shown, each of sliders 26 and 30 is equipped with position sensors (not shown), and while inputting position information obtained from the position sensors thereof, control device 60 controls driving motor 26a and 30a of each of sliders 26 and 30.

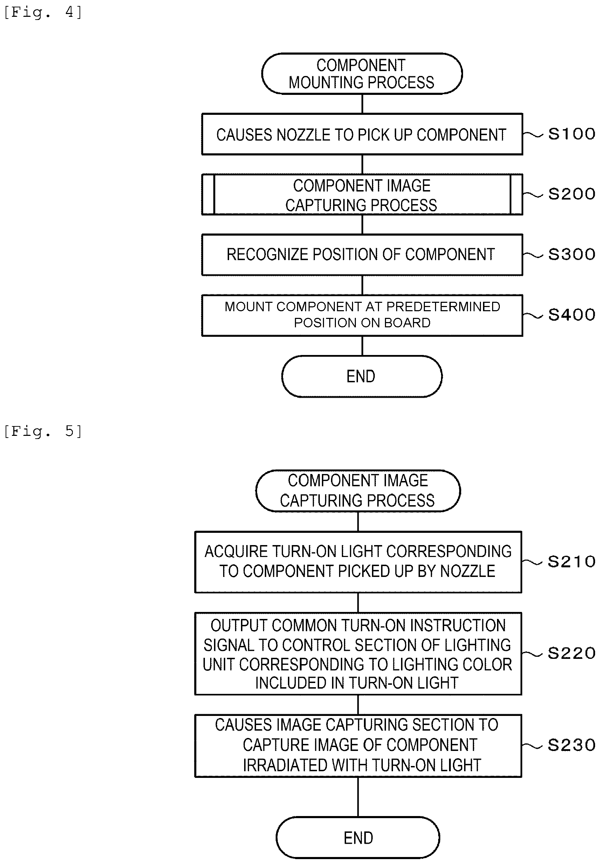

Next, an operation in a case where component mounting machine 10 performs a component mounting process will be described. CPU 61 of control device 60 controls each section of the component mounting machine 10 based on a production job received from a management computer (not shown) to produce board 16 on which multiple components are mounted. The production job is information defining which components are mounted on board 16 in which order and the number of boards 16 on which components are mounted in component mounting machine 10. Fig. 4 is a flowchart of the component mounting process. In a case where component mounting process shown in Fig. 4 is started, first, CPU 61 causes the nozzle 37 to pick up the component (S100). Specifically, CPU 61 controls each section so that nozzle 37 faces the component fed to a predetermined component supply position by reel unit 70, and supplies the negative pressure to nozzle 37 so that the component at the predetermined component supply position is picked up by nozzle 37. Next, CPU 61 executes the component image capturing process (S200). Specifically, CPU 61 moves the component, which is picked up by nozzle 37, to a capturing region above component camera 40, causing component camera 40 to capture the component. Details of this component image capturing process will be described later. Subsequently, CPU 61 recognizes a position of the component with respect to a center of nozzle 37 from the obtained image of the component (S300). Subsequently, CPU 61 mounts the component picked up by nozzle 37 on board 16 (S400). Specifically, CPU 61 controls each section so that the component is disposed directly at the predetermined position on board 16 in consideration of the position of the component with respect to the center of nozzle 37, and supplies the positive pressure to nozzle 37 so that nozzle 37 releases the component at the position. CPU 61 repeatedly executes the component mounting process to mount a predetermined number and types of components on board 16.

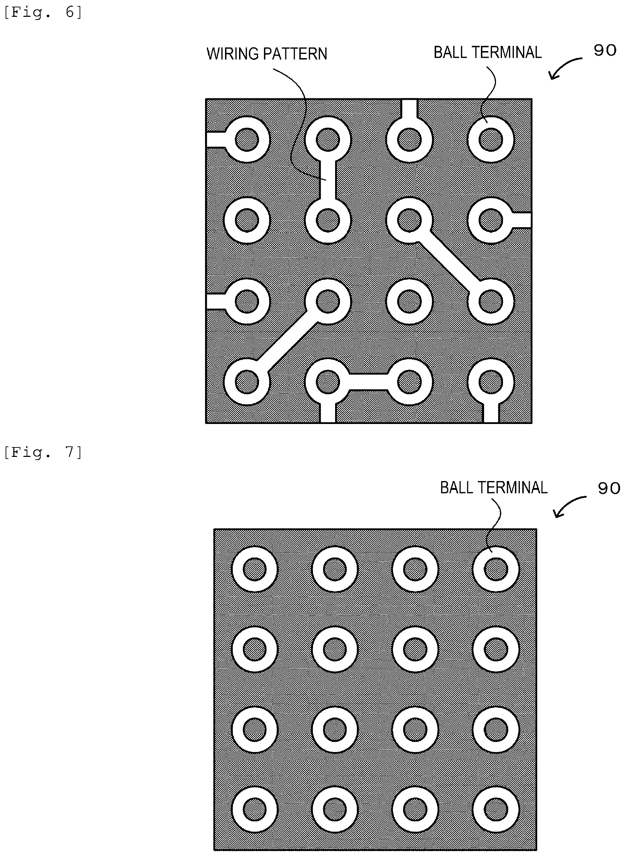

Next, the component image capturing process in the above-described S200 will be described. Fig. 5 is a flowchart of the component image capturing process. In a case of starting the component image capturing process shown in Fig. 5, CPU 61 firstly reads out and acquires turn-on light corresponding to the component picked up by nozzle 37 from a table (refer to Table 1) stored in storage section 63, the table representing a correspondence relationship between the component and the turn-on light (S210). For example, BGA package 90 is a component in which multiple ball terminals are formed into a lattice shape and a copper wiring pattern is formed on a lower surface of the main body thereof. In a case of capturing the ball terminals of BGA package 90, when the ball terminals are irradiated with red light for capturing, not only the ball terminals but also the wiring pattern are captured, resulting in the occurrence of an image processing error (refer to Fig. 6). However, when the ball terminals are irradiated with blue light for capturing, the capturing of the wiring pattern can be avoided, which turns out avoiding the occurrence of image processing error (refer to Fig. 7). Therefore, a turn-on color for BGA package 90 is set to blue light. In a case of capturing the ball terminals of BGA package 90, the blue light is desirably irradiated only from a laterally light emitting light source. Annular bright rings denote the ball terminals in Figs. 6 and 7. An LGA package is a component (with no copper wiring pattern) in which a planar electrode is embedded in the bottom surface of the main body, the corresponding turn-on light is set to red light. A small outline package (SOP) is a component in which multiple leads are formed on both side surfaces of the main body, and the corresponding turn-on light is set to blue light and red light.

**[Table 1]**

| component | turn-on light |
|---|---|
| BGA | blue light |
| LGA | red light |
| SOP | blue light + red light |

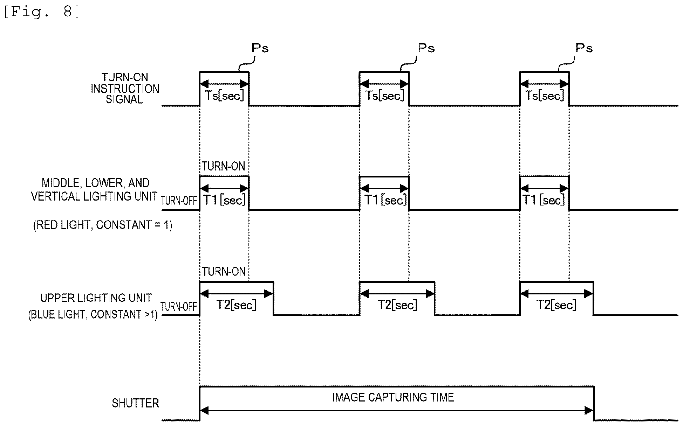

Subsequently, CPU 61 outputs a common turn-on command signal to the control section of the lighting unit corresponding to the lighting color included in the turn-on light acquired this time (S220). An example of the turn-on command signal is shown in Fig. 8. The turn-on command signal is a signal in which the same turn-on command pulse Ps is generated multiple times at equal intervals with respect to a time period (capturing time) during which a shutter of image capturing section 51 is opened (three times in Fig. 8). In order to light the light emitting element, it is necessary to instantaneously flow a large current, and it is necessary to prepare for the next lighting by charging after lighting. In a case where the turn-on command pulse is generated only once for the capturing time, a size of a device is increased, but the device is miniaturized by generating turn-on command pulse Ps multiple times for the capturing time. Pulse width time Ts of turn-on command pulse Ps, that is, the time from a rising edge to a falling edge of turn-on command pulse Ps, is an index representing how much light amount control device 60 requires. Usually, the capturing time is on an order of msec, and pulse width time Ts of turn-on command pulse Ps is on an order of µsec. For example, in a case where the lighting color included in the turn-on light acquired this time is red light, CPU 61 outputs the turn-on command signal to middle control section 49b, lower control section 49c, and vertical control section 50. On the other hand, in a case where the lighting color included in the turn-on light acquired this time is blue light, CPU 61 outputs the turn-on command signal to upper control section 49a. In a case where the lighting color included in the turn-on light acquired this time is both red light and blue light, CPU 61 outputs the turn-on command signal to all control sections 49a to 49c, and 50. Subsequently, CPU 61 causes image capturing section 51 to capture a component irradiated with the turn-on light (S230). An image captured by image capturing section 51 is stored in storage section 63.

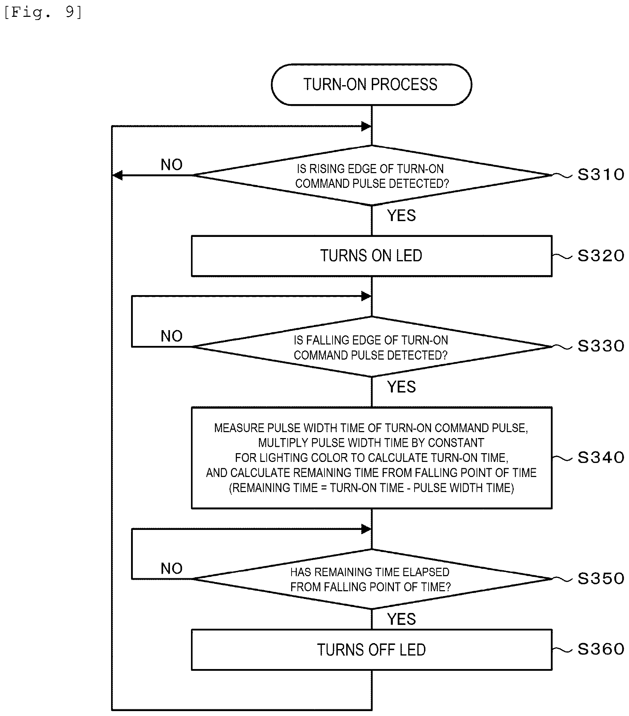

Next, the turn-on process of upper, middle, and lower control sections 49a to 49c and vertical control section 50 will be described. Fig. 9 is a flowchart of the turn-on process. Since this turn-on process is common to each of control sections 49a to 49c, and 50, each of control sections 49a to 49c, and 50 will not be distinguished and will be simply referred to as "control section" below.

In a case where the turn-on process of Fig. 9 is started, the control section first determines whether the rising edge of turn-on command pulse Ps is detected (S310), and in a case where it is not detected, the control section waits as it is. At this time, the LED of the lighting unit corresponding to the control section is turned off. On the other hand, in a case where the rising edge of turn-on command pulse Ps is detected in S310, the control section turns on the LED of the lighting unit corresponding to the control section (S320). Subsequently, the control section determines whether the falling edge of turn-on command pulse Ps is detected (S330), and in a case where it is not detected, the control section waits as it is. On the other hand, in a case where the falling edge of turn-on command pulse Ps is detected in S330, the control section measures the time from the rising edge to the falling edge of turn-on command pulse Ps, that is, pulse width time Ts, using a counter (not shown), multiplies pulse width time Ts by a constant set for each lighting color to calculate the turn-on time, and calculates a remaining time (= turn-on time - pulse width time) from a falling point of time (S340). Subsequently, the control section determines whether the remaining time has elapsed from the falling point of time of turn-on command pulse Ps (S350), and in a case where the remaining time has not elapsed, the control section waits as it is and the turn-on state is maintained. On the other hand, in a case where the remaining time has elapsed from the falling point of time of turn-on command pulse Ps in S350, the control section turns off the LED of the lighting unit corresponding to the control section (S360), and returns to S310. Thus, the LED is turned on for the turn-on time calculated by multiplying the pulse width time Ts by the constant set for each lighting unit from the rising edge of turn-on command pulse Ps included in the turn-on command signal. Specifically, the LED is turned on from the rising edge to the falling edge of turn-on command pulse Ps, and the LED is turned on by extending the turn-on time until the remaining time elapses from the falling edge of turn-on command pulse Ps.

Next, a constant set for each lighting color will be described. The brightness of the blue LED is lower than that of the red LED. Therefore, in a case where both LEDs are turned on for the same time, the light amount of the blue LED becomes smaller than the light amount of the red LED. In the present embodiment, the red LED is turned on in a case where turn-on command pulse Ps rises and is turned off in a case where it falls. Therefore, turn-on time T1 [sec] of the red LED is the same as pulse width time Ts, the constant of the red light is set to 1. On the other hand, since turn-on time T2 [sec] of the blue LED is set to be longer than turn-on time T1 of the red LED, the constant of the blue light is set to a value larger than 1 (for example, 1.2 or 1.4.). By setting turn-on time T2 of the blue LED longer than the turn-on time T1 of the red LED in this manner, the exposure amount (brightness) by the blue LED can be made equal to the exposure amount by the red LED. The constant is stored in advance in a memory of the control section, and the control section reads the constant from the memory and uses it as necessary.

Here, a correspondence relationship between a configuration element of the present embodiment and a configuration element of the image capturing unit of the present disclosure will be described. Component camera 40 of the present embodiment corresponds to the camera for capturing the component images of the present disclosure, vertical lighting unit 44 and upper, middle, and lower lighting units 47a to 47c correspond to the lighting unit, image capturing section 51 corresponds to the image capturing unit, and vertical control section 50 and upper, middle, and lower control sections 49a to 49c correspond to the lighting unit control section. In addition, reel unit 70 corresponds to the component supply portion, nozzle 37 corresponds to the holding portion, and control device 60 corresponds to the mounting machine controller.

In the present embodiment described above, control sections 49a to 49c, and 50 calculate the turn-on time by multiplying pulse width time Ts, which is an index representing how much light amount control device 60 requires, by a constant set for each of lighting units 44 and 47a to 47c. That is, control device 60 only outputs a common turn-on command signal to lighting units 44, and 47a to 47c, and each of lighting units 44 and 47a to 47c calculates a suitable turn-on time and turns on the light. Therefore, with component camera 40 of the present embodiment, it is possible to easily set the turn-on time for each of the lighting units 44, and 47a to 47c using pulse width time Ts of turn-on command pulse Ps output from control device 60.

In addition, since each of control sections 49a to 49c and 50 know pulse width time Ts when turn-on command pulse Ps falls, the turn-on time can be calculated based on pulse width time Ts and the constant, and the remaining time of the turn-on time (= turn-on time - pulse width time) can be calculated.

Further, since the constant is set according to a characteristic (lighting color that is a factor of brightness) for each of lighting units 44 and 47a to 47c, the turn-on time suitable for each of lighting units 44 and 47a to 47c can be set.

Furthermore, blue upper lighting unit 47a can also obtain the same light amount as red vertical, middle, and lower lighting unit 44, 47b, and 47c.

It is needless to say that the present invention is not limited to the above-described embodiments, and can be implemented in various aspects as long as it belongs to the technical scope of the present invention.

For example, in the above-described embodiment, the constant is set according to the lighting color of each of lighting units 44 and 47a to 47c, but may be set according to other characteristics other than the lighting color. Other characteristics other than the lighting color include, for example, an irradiation angle with respect to the component. In addition, the constant may be set according to the characteristic of image capturing section 51. The characteristic of image capturing section 51 includes, for example, a brightness of the lens, an aperture, a performance of the capturing element (CCD, and the like), and the like. Further, the constant may be set according to one or more characteristics of each of lighting units 44 and 47a to 47c, or may be set according to one or more characteristics of each of lighting units 44 and 47a to 47c and one or more characteristics of image capturing section 51.

In the embodiment described above, control device 60 may be variable pulse width time Ts of turn-on command pulse Ps. For example, pulse width time Ts may be changed in accordance with components or the type of image capturing section 51 (or a lens, or a capturing element).

In the above-described embodiment, the constants of each of control sections 49a to 49c and 50 may be different for each component or may be different for each model of image capturing section 51 (or for a lens, or an imaging element).

In the above-described embodiment, three types of the turn-on light including the blue light, the red light, and the blue light and the red light are used as an example, but the configuration is not limited to this, and other turn-on light (for example, green light, UV light, or IR light) may be used instead of or in addition to the above-described turn-on light.

In the above-described embodiment, component camera 40 is exemplified as the camera for capturing the component images of the present disclosure, but the configuration is not limited to this, and any camera may be used as long as the camera has a multicolor lighting device.

In the above-described embodiment, control device 60 is exemplified as a higher-order unit, but the configuration is not limited to this, and for example, in a case where image capturing section 51 has a control section, the control section may be the control section of image capturing section 51.

In the above-described embodiment, nozzle 37 is exemplified as the holding portion for holding the component, but the configuration is not limited to this, and a mechanical chuck or an electromagnet may be used, for example.

In the above-described embodiment, reel unit 70 is exemplified as the component supply portion, but the configuration is not limited to this, and for example, a tray unit in which components are placed on a tray and supplied may be adopted.

The camera for capturing the component images of the present disclosure and the component mounting machine of the present disclosure may be configured as follows.

In the camera for capturing the component images of the present disclosure, in a case of turning on the light emitting element for the turn-on time from the rising edge of the turn-on command pulse included in the turn-on command signal, the lighting unit control section may be configured to turn on the light emitting element from the rising edge to a falling edge of the turn-on command pulse, measure the pulse width time, multiply the measured pulse width time by the constant to calculate the turn-on time, and turn on the light emitting element by extending the turn-on time until a remaining time obtained by subtracting the pulse width time from the turn-on time elapses from the falling edge. Thus, since the pulse width time is known when the turn-on command pulse falls, the turn-on time can be calculated based on the pulse width time, and the remaining time of the turn-on time (= turn-on time - pulse width time) can be calculated.

In the camera for capturing the component images of the present disclosure, the constant may be set according to a characteristic of each lighting unit, or may be set according to a characteristic of each lighting unit and a characteristic of the image capturing unit. In this way, it is possible to set the turn-on time suitable for each lighting unit. Here, the characteristics include, for example, elements of brightness. The elements of brightness include, for example, the lighting color and the irradiation angle with respect to the component. In addition, the characteristics of the image capturing unit include the brightness of the lens and the performance of the capturing element.

In the camera for capturing the component images of the present disclosure, the multiple lighting units may be configured to include at least a lighting unit of which a lighting color is red and a lighting unit of which a lighting color is blue, in a case where the turn-on command signal is input, a control section of the red lighting unit may be configured to turn on the light emitting element for a turn-on time calculated by multiplying the pulse width time of the turn-on command pulse by a constant corresponding to red from the rising edge of the turn-on command pulse included in the turn-on command signal, and in a case where the turn-on command signal is input, a control section of the blue lighting unit may be configured to turn on the light emitting element for a turn-on time calculated by multiplying the pulse width time of the turn-on command pulse by a constant, corresponding to blue and having a value larger than the constant for red from the rising edge of the turn-on command pulse included in the turn-on command signal. In a case where the blue lighting unit and the red lighting unit are turned on for the same turn-on time, the light amount is usually insufficient in the blue. Therefore, in the blue lighting unit, the light emitting element is turned on for the turn-on time calculated by multiplying the pulse width time of the turn-on command pulse by a constant of a value larger than red according to blue. In this way, the blue lighting unit also becomes to obtain the same light amount as the red lighting unit.

The component mounting machine of the present disclosure includes a mounting machine controller configured to control a holding portion and a component camera so that the holding portion holds a component supplied from a component supply portion and then the holding portion moves to a predetermined position on a board via a capturing region of the component camera and releases the component, in which the component camera may be any of camera for capturing the component images described above, and the mounting machine controller may be a higher-order unit. With this component mounting machine, since any of camera for capturing the component images described above is provided, the same effect as any of the camera for capturing the component images described above can be obtained.

### Industrial applicability

The present invention can be used for an industry involving work for capturing the component images.

### Reference Signs List

10: component mounting machine12: base14: mounting machine body16: board18: board conveyance device20: support plate22: conveyor belt23: support pin24: head26: X-axis slider26a: driving motor28: guide rail30: Y-axis slider30a: driving motor32: guide rail34: Z-axis motor35: ball screw36: Q-axis motor37: nozzle40: component camera41: lighting section42: housing43: connecting portion44: vertical lighting unit45: LED46: half mirror47: multi-stage lighting section47a: upper lighting unit47b: middle lighting unit47c: lower lighting unit48a to 48c: LED49a: upper control section49b: middle control section49c: lower control section50: vertical control section51: image capturing section51a: optical axis60: control device61: CPU63: storage section65: input and output interface66: bus70: reel unit72: reel74: feeder section76: feeder controller90: BGA package

## Claims

1. A camera for capturing component images comprising:
multiple lighting units configured to irradiate components with light of a light emitting element;
an image capturing unit configured to capture the components irradiated with the light; and
multiple lighting unit control sections configured to be provided for the lighting units, respectively;
**characterized in that**
each of the lighting unit control sections is configured to turn on, in a case where a common turn-
on command signal for the multiple lighting unit control sections including a turn-on command pulse is input from a unit separate from the lightning unit control section, the light emitting element for a turn-on time from a rising edge of the turn-on command pulse included in the turn-on command signal, wherein
the turn-on time is calculated by multiplying a pulse width time of the turn-on command pulse by a constant, the constant being set for the lighting unit and stored in a memory of the lightning control section.

2. The camera for capturing the component images according to claim 1, wherein
in a case of turning on the light emitting element for the turn-on time from the rising edge of the turn-on command pulse included in the turn-on command signal, the lighting unit control section is configured to
turn on the light emitting element from the rising edge to a falling edge of the turn-on command pulse, measure the pulse width time,
multiply the measured pulse width time by the constant to calculate the turn-on time, and
turn on the light emitting element by extending the turn-on time until a remaining time obtained by subtracting the pulse width time from the turn-on time elapses from the falling edge.

3. The camera for capturing the component images according to claim 1 or 2, wherein
the constant is set according to a characteristic of each lighting unit, or
is set according to the characteristic of each lighting unit and a characteristic of the image capturing unit; wherein
the characteristic of each lighting unit include an element of brightness, and
the characteristic of the image capturing unit include a brightness of a lens of the image capturing unit, an aperture, and a performance of a capturing element of the image capturing unit.

4. The camera for capturing the component images according to claim 3, wherein
the multiple lighting units is configured to include at least a lighting unit of which a lighting color is red and a lighting unit of which a lighting color is blue,
in a case where the turn-on command signal is input, a control section of the red lighting unit is configured to turn on the light emitting element for a turn-on time calculated by multiplying the pulse width time of the turn-on command pulse by a constant corresponding to red from the rising edge of the turn-on command pulse included in the turn-on command signal, and
in a case where the turn-on command signal is input, a control section of the blue lighting unit is configured to turn on the light emitting element for a turn-on time calculated by multiplying the pulse width time of the turn-on command pulse by a constant, corresponding to blue and having a value larger than the constant for red from the rising edge of the turn-on command pulse included in the turn-on command signal.

5. A component mounting machine comprising:
a mounting machine controller configured to:
- control a holding portion and a component camera so that the holding portion holds a component supplied from a component supply portion and then the holding portion moves to a predetermined position on a board via a capturing region of the component camera and releases the component, and
- input a turn-on command signal including a turn-on command pulse to the component camera, wherein
the component camera is the camera for capturing the component images according to any one of claims 1 to 4.

## Patentansprüche

1. Kamera zur Aufnahme von Komponentenbildern, aufweisend:
mehrere Beleuchtungseinheiten, die so konfiguriert sind, dass sie Komponenten mit Licht eines lichtemittierenden Elements bestrahlen;
eine Bilderfassungseinheit, die so konfiguriert ist, dass sie die mit dem Licht bestrahlten Komponenten erfasst; und
mehrere Beleuchtungseinheits-Steuerabschnitte, die so konfiguriert sind, dass sie jeweils für die Beleuchtungseinheiten bereitgestellt werden;
**dadurch gekennzeichnet, dass**
jeder der Beleuchtungseinheits-Steuerabschnitte so konfiguriert ist, dass er in einem Fall, in dem ein gemeinsames Einschalt-Befehlssignal für die mehreren Beleuchtungseinheits-Steuerabschnitte, das einen Einschalt-Befehlsimpuls enthält, von einer von dem Beleuchtungseinheits-Steuerabschnitt getrennten Einheit eingegeben wird, das lichtemittierende Element für eine Einschaltzeit ab einer ansteigenden Flanke des in dem Einschalt-Befehlssignal enthaltenen Einschalt-Befehlsimpulses einschaltet, wobei
die Einschaltzeit durch Multiplizieren einer Impulsbreitenzeit des Einschalt-Befehlsimpulses mit einer Konstante berechnet wird, wobei die Konstante für die Beleuchtungseinheit eingestellt und in einem Speicher des Beleuchtungs-Steuerabschnitts gespeichert wird.

2. Kamera zur Aufnahme der Komponentenbilder nach Anspruch 1, wobei
in einem Fall des Einschaltens des lichtemittierenden Elements für die Einschaltzeit ab der ansteigenden Flanke des Einschalt-Befehlsimpulses, der in dem Einschalt-Befehlssignal enthalten ist, der Beleuchtungseinheit-Steuerabschnitt konfiguriert ist, um
das lichtemittierende Element von der steigenden Flanke bis zu einer fallenden Flanke des Einschalt-Befehlsimpulses einzuschalten, die Impulsbreitenzeit zu messen,
die gemessene Impulsbreitenzeit mit der Konstante zu multiplizieren, um die Einschaltzeit zu berechnen, und
das lichtemittierende Element einzuschalten, indem die Einschaltzeit verlängert wird, bis eine Restzeit, die sich aus der Subtraktion der Impulsbreitenzeit von der Einschaltzeit ergibt, nach der fallenden Flanke verstrichen ist.

3. Kamera zur Aufnahme der Komponentenbilder nach Anspruch 1 oder 2, wobei
die Konstante entsprechend einer Charakteristik jeder Beleuchtungseinheit eingestellt wird, oder
entsprechend der Charakteristik jeder Beleuchtungseinheit und einer Charakteristik der Bilderfassungseinheit eingestellt ist; wobei
die Charakteristik jeder Beleuchtungseinheit ein Helligkeitselement enthält, und
die Charakteristik der Bilderfassungseinheit eine Helligkeit eines Objektivs der Bilderfassungseinheit, eine Blende und eine Leistung eines Aufnahmeelements der Bilderfassungseinheit einschließt.

4. Kamera zur Aufnahme der Komponentenbilder nach Anspruch 3, wobei
die mehreren Beleuchtungseinheiten so konfiguriert sind, dass sie mindestens eine Beleuchtungseinheit, deren Beleuchtungsfarbe rot ist, und eine Beleuchtungseinheit, deren Beleuchtungsfarbe blau ist, umfassen,
in einem Fall, in dem das Einschaltbefehlssignal eingegeben wird, ein Steuerabschnitt der roten Beleuchtungseinheit konfiguriert ist, um das lichtemittierende Element für eine Einschaltzeit einzuschalten, die durch Multiplizieren der Impulsbreitenzeit des Einschalt-Befehlsimpulses mit einer Konstante, die Rot entspricht, von der ansteigenden Flanke des Einschalt-Befehlsimpulses, der in dem Einschalt-Befehlssignal enthalten ist, berechnet wird, und
in einem Fall, in dem das Einschalt-Befehlssignal eingegeben wird, ein Steuerabschnitt der blauen Beleuchtungseinheit konfiguriert ist, um das lichtemittierende Element für eine Einschaltzeit einzuschalten, die durch Multiplizieren der Impulsbreitenzeit des Einschalt-Befehlsimpulses mit einer Konstante berechnet wird, die Blau entspricht und einen Wert hat, der größer ist als die Konstante für Rot von der ansteigenden Flanke des Einschalt-Befehlsimpulses, der in dem Einschalt-Befehlssignal enthalten ist.

5. Eine Komponenten-Montagemaschine, aufweisend:
eine Montiermaschinensteuerung, die konfiguriert ist, um:
- einen Halteabschnitt und eine Komponentenkamera so zu steuern, dass der Halteabschnitt eine von einem Komponentenzuführabschnitt zugeführte Komponente hält und sich dann der Halteabschnitt über einen Erfassungsbereich der Komponentenkamera zu einer vorbestimmten Position auf einer Platine bewegt und die Komponente freigibt, und
- Eingeben eines Einschaltbefehlssignals einschließlich eines Einschalt-Befehlsimpulses in die Komponentenkamera, wobei
die Komponentenkamera die Kamera zur Aufnahme der Komponentenbilder nach einem der Ansprüche 1 bis 4 ist.

## Revendications

1. Caméra pour capturer des images de composant comprenant :
de multiples unités d'éclairage configurées pour irradier des composants avec de la lumière d'un élément électroluminescent ;
une unité de capture d'images configurée pour capturer les composants irradiés avec la lumière ; et
de multiples sections de commande d'unité d'éclairage configurées pour être fournies pour les unités d'éclairage, respectivement ;
**caractérisée en ce que**
chacune des sections de commande d'unité d'éclairage est configurée pour mettre sous tension, dans un cas où un signal d'instruction de mise sous tension commun pour les multiples sections de commande d'unité d'éclairage comprenant une impulsion d'instruction de mise sous tension est entré à partir d'une unité séparée de la section de commande d'unité d'éclairage, l'élément électroluminescent pendant un temps de mise sous tension à partir d'un front montant de l'impulsion d'instruction de mise sous tension comprise dans le signal d'instruction de mise sous tension,
dans laquelle
le temps de mise sous tension est calculé en multipliant un temps de largeur d'impulsion de l'impulsion d'instruction de mise sous tension par une constante, la constante étant établie pour l'unité d'éclairage et stockée dans une mémoire de la section de commande d'éclairage.

2. Caméra pour capturer les images de composant selon la revendication 1, dans laquelle
dans le cas de la mise sous tension de l'élément électroluminescent pendant le temps de mise sous tension à partir du front montant de l'impulsion d'instruction de mise sous tension comprise dans le signal d'instruction de mise sous tension, la section de commande d'unité d'éclairage est configurée pour
mettre sous tension l'élément électroluminescent à partir du front montant jusqu'à un front descendant de l'impulsion d'instruction de mise sous tension, mesurer le temps de largeur d'impulsion,
multiplier le temps de largeur d'impulsion mesuré par la constante pour calculer le temps de mise sous tension, et
mettre sous tension l'élément électroluminescent en prolongeant le temps de mise sous tension jusqu'à ce qu'un temps restant, obtenu en soustrayant le temps de largeur d'impulsion du temps de mise sous tension, s'écoule à partir du front descendant.

3. Caméra pour capturer les images de composant selon la revendication 1 ou 2, dans laquelle
la constante est établie en fonction d'une caractéristique de chaque unité d'éclairage, ou
est établie en fonction de la caractéristique de chaque unité d'éclairage et d'une caractéristique de l'unité de capture d'images ; dans laquelle
la caractéristique de chaque unité d'éclairage comprend un élément de luminosité, et la caractéristique de l'unité de capture d'images comprend une luminosité d'une lentille de l'unité de capture d'images, une ouverture et une performance d'un élément de capture de l'unité de capture d'images.

4. Caméra pour capturer les images de composant selon la revendication 3, dans laquelle
les multiples unités d'éclairage sont configurées pour comprendre au moins une unité d'éclairage dont une couleur d'éclairage est rouge et une unité d'éclairage dont une couleur d'éclairage est bleue,
dans un cas où le signal d'instruction de mise sous tension est entré, une section de commande de l'unité d'éclairage rouge est configurée pour mettre sous tension l'élément électroluminescent pendant un temps de mise sous tension calculé en multipliant le temps de largeur d'impulsion de l'impulsion d'instruction de mise sous tension par une constante correspondant au rouge à partir du front montant de l'impulsion d'instruction de mise sous tension comprise dans le signal d'instruction de mise sous tension, et
dans un cas où le signal d'instruction de mise sous tension est entré, une section de commande de l'unité d'éclairage bleu est configurée pour mettre sous tension l'élément électroluminescent pendant un temps de mise sous tension calculé en multipliant le temps de largeur d'impulsion de l'impulsion d'instruction de mise sous tension par une constante, correspondant au bleu et ayant une valeur supérieure à la constante pour le rouge à partir du front montant de l'impulsion d'instruction de mise sous tension comprise dans le signal d'instruction de mise sous tension.

5. Machine de montage de composants comprenant :
un dispositif de commande de machine de montage configuré pour :
- commander une partie de maintien et une caméra de composants de sorte que la partie de maintien maintient un composant fourni par une partie d'alimentation en composants, puis la partie de maintien se déplace vers une position prédéterminée sur un panneau via une région de capture de la caméra de composants et libère le composant, et
- entrer un signal d'instruction de mise sous tension comprenant une impulsion d'instruction de mise sous tension dans la caméra de composants, dans laquelle la caméra de composants est la caméra destinée à capturer les images de composant selon l'une quelconque des revendications 1 à 4.
